# EUROPEAN PATENT APPLICATION

(11) **EP 1 458 090 A1**
(43) Date of publication of application: **15.09.2004**
(21) Application number: 03290587.9
(22) Date of filing: 10.03.2003
(51) Int. Cl.: H03F 3/45

(54) **Electronic integrated circuit comprising a differential amplifier with digital compensation of the DC offset voltage**

(71) Applicant: ALCATEL, 75008 Paris (FR)
(72) Inventor: Ballentin, Ralph, 16547 Birkenwerder (DE)
(74) Representative: Brose, Gerhard

(57) **Abstract**

The invention relates to an electronic integrated circuit comprising a differential amplifier (DIFF) with an associated digital DC offset compensation loop circuit which compensates the offset voltage between the outputs (OUTP,OUTPI) of the amplifier, the amplifier having a current feedback differential amplifier construction in which the emitters of the pair of transistors (Q0,Q1) forming the differential amplifier (DIFF) are connected by a resistor (R4) and the emitter current of the transistors is provided by two current sources (I2,I3), and the digital DC offset voltage compensation loop providing means to modify the value of the current sources. The invention also relates to a method for amplifying a radio frequency (RF) signal using the electronic integrated circuit described above.

## Description

The present invention relates to the field of differential amplifiers, especially current feedback differential amplifiers, and more particularly to the correction of the offset voltage of such amplifiers. An electronic integrated circuit comprising a differential amplifier circuit which has an active direct current (DC) differential output offset voltage compensation circuit is disclosed. Also a method for amplifying a radio frequency (RF) signal using said electronic circuit is described.

A major problem related to analog integrated circuits with differential amplifiers is well known, it lies in the significant offset voltage which appears between the two amplifier outputs, due to either offset voltage present in the amplifier inputs introduced by prior circuit stages or to integrated circuit device manufacture tolerance, bias or operating characteristics of the differential amplifier. This potential difference at the differential output of a differential amplifier is referred to as direct current offset voltage and it is important enough to justify compensation.

Some techniques for forcing the differential output of a differential amplifier to have a zero DC differential value are known to the applicant. For example US Pat. 4,460,873 discloses an integrated circuit differential amplifier having an analog feedback loop to compensate the offset voltage due to bias or operating characteristics of the system, the feedback loop comprising a voltage peak detection system in order to isolate direct current voltage values from alternating currents voltage values appearing at the differential amplifier output, and this direct current peak detected value controlling a current source which sums its output current to the current output of the differential amplifier.

Also in US Pat. 4,395,681, which is considered here the closest State of the Art, a digital compensation loop is used for compensating an offset voltage which appears between two amplifier differential inputs, the digital compensation loop comprising a comparator, an n-bit up/down counter and a digital-to-analog converter. The loop is connected to the input signals so as to modulate them.

A main disadvantage of the mentioned Prior Art is that the frequency characteristics of the signal to be amplified are influenced by the feedback compensation loop. Indeed, when connecting an electronic circuit to the differential inputs of the amplifier, the input signal is influenced by the parasitic frequency characteristics (due to capacitance, inductance, etc) introduced by the electronic circuit, and when working with signals with frequencies of 10 GHz or more, the compensation loop influence is not negligible.

The object of the invention is to propose an electronic integrated circuit comprising a differential amplifier having a digital compensation feedback loop to correct a tendency to have a DC offset voltage inherent in the differential amplifier output due to differential amplifier elements tolerance, without affecting the frequency characteristics of the signal which has to be amplified.

The object is achieved according to the invention by an electronic integrated circuit comprising a differential amplifier with an associated digital DC offset compensation loop circuit which compensates the offset voltage present at the output of the amplifier wherein said amplifier has a current feedback differential amplifier construction, in which the emitters of the pair of transistors forming the differential amplifier are connected by a resistor and the emitter current of said transistors is provided by two current sources, and the digital DC offset voltage compensation loop provides means to modify the value of said current sources.

The object is also achieved by a method for amplifying a radio frequency (RF) signal using an electronic integrated circuit comprising a differential amplifier with an associated digital DC offset compensation loop circuit which compensates the offset voltage present at the output of the amplifier wherein the amplification is done by a differential amplifier with current feedback construction, in which the emitters of the pair of transistors forming the differential amplifier are connected by a resistor and the emitter current of said transistors is provided by two current sources, and the digital DC offset compensation loop circuit modifies the value of said current sources.

Advantageous configurations of the invention emerge from the dependent claims, the following description and the drawings.

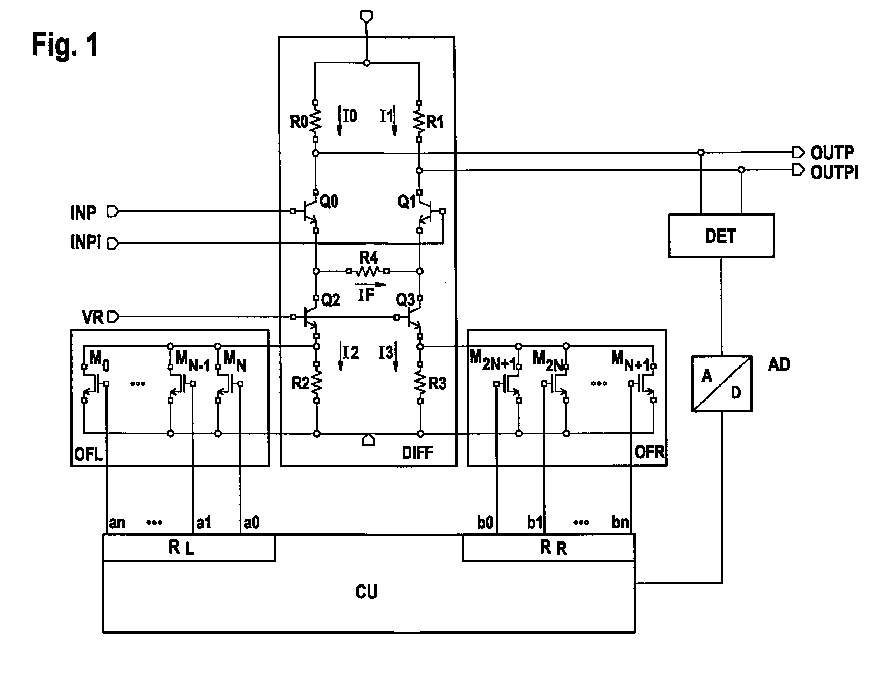

An embodiment example of the invention is now explained with the aid of Figure 1.

Figure 1 shows a block and electronic diagram of the electronic integrated circuit according to the invention.

Figure 1 shows the electronic integrated circuit comprising a current feedback differential amplifier DIFF with two differential signal inputs INP, INPI and outputs OUTP, OUTPI, the outputs connected to a digital feedback loop comprising an offset detector DET, an analog-to-digital converter AD, a control unit CU comprising two registers RL and RR whose outputs are connected to current compensating circuits OFL and OFR which are respectively connected to resistors R2 and R3 of the differential amplifier to close the loop.

Current feedback differential amplifiers are characterized by having feedback current which goes through a resistance connecting the pair of amplifier transistor emitters. One possible practical solution, the invention preferred solution, is the one shown in Figure 1, on which this is realized by connecting the emitter of transistors Q0 and Q1 by resistor R4. Resistor R4 is needed so that both transistors Q0 and Q1 work in the same lineal operating point of their transfer function and by adjusting its value it is possible to regulate the gain of the signal output. In the preferred realization of the invention, the differential amplifier DIFF also comprises two current sources I2 and I3 which are connected to the emitters of transistors Q0 and Q1 respectively. A way to implement current sources I2 and I3 is by means of a transistor stimulated by a voltage reference value and a resistor connected to the emitter of said transistor. As shown in the figure, I2 is controlled by reference voltage VR, transistor Q2 and resistor R2, and on the other hand, current source I3 is controlled by reference voltage VR, transistor Q3 and resistor R3. Assuming a fixed value for reference voltage VR, the value of the current sources I2 and I3 will depend on the resistance connected to the emitter of Q2 and Q3 respectively.

In an ideal behaviour of the current feedback differential amplifier, the following rules would apply, under the assumption that the value of the signal at both amplifier inputs is equal: I0=I1, I2=I3, IF=0 and voltage in first differential output OUTP equals voltage in second differential output OUTPI, but because of the differential amplifiers components tolerance, that is, each element does not present an ideal behaviour, currents I0 and I1 may vary also from the ideal value and thus a DC offset voltage may be introduced in the signal output, which is not desirable. To avoid this to happen, the invention proposes a digital compensating loop which modifies the values of currents I2 and I3 accordingly so that variations in current I0 and I1 of the ideal values are compensated in a way such that the DC offset voltage between outputs OUTP and OUTPI is maintained zero.

According to the explanation given above, currents I2 and I3 will depend on the resistance connected to the emitter of Q2 and Q3 respectively. The resistance value can be modified by current compensating circuits OFL and OFR, which in a preferred embodiment of the invention are realized by a plurality of NMOS transistors M₀ to M_{N} and M_{N+1} to M_{2N+1}, connected in parallel to resistors R2 and R3 respectively. The NMOS transistors when activated by applying a DC voltage act as a resistance connected in parallel to resistors R2 and R3, thus modifying the equivalent resistance seen at the emitter of transistors Q2 and Q3.

The number of transistors, for each current compensating circuit OFL and OFR, depends on the accuracy or granularity to be achieved in which the currents I2 and I3 shall be modified, that is, with more transistors per current compensating circuit OFL and OFR more accuracy or granularity is achieved. For example, if N=3 , then we have 2N+2=8 NMOS transistors in total and N+1=4 transistors per current compensating circuit OFR, OFL. The current compensating circuit OFR will comprise transistors M₀ to M₃ and circuit OFL transistors M₄ to M₇. A granularity of 2^{N+1}= 16 different resistance values will be achievable if we assume that every NMOS has a different resistance value which is connected in parallel to resistors R2 or R3 and implicitly 2^{N+1}=16 different current I2 and I3 values.

The activation/deactivation of the transistors of each current compensating circuit OFR and OFL will depend on the current compensation needed for I0 and I1, which depend on I2 and I3. According to a preferred embodiment of the invention, a digital control unit CU is in charge of implementing the algorithm by which the transistors M₀ to M_{2N+1} shall be activated/deactivated. The control unit CU receives information from the digital to analog converter AD about the DC offset voltage value which is present between the outputs OUTP and OUTPI of the differential amplifier DIFF. The CU reads this value and actuates on registers RR and RL which in turn activate/deactivate the corresponding transistors of the current compensating circuits OFL and OFR. One way of activating the transistors may follow an iterative process by which the value of the equivalent resistance is halved in every iteration until the DC offset voltage at the output of the differential amplifier reaches zero. Also the symmetric approach, that is, by doubling the value of the equivalent resistance in every iteration, may be followed. Another approach to activate the transistors may be used so that the value of the equivalent resistance is iteratively decremented/incremented by small values in a step-wise manner. Instead of a control unit CU which follows a determined algorithm, also an up/down counter element could be used to stimulate the transistors M₀ to M_{2N+1} to implement the small value decrement/increment approach.

It should be noticed that current compensating circuits OFL and OFR only actuate on the resistors R2 and R3 of the differential amplifier DIFF. With this method we achieve an amplification of the RF signal without affecting or influencing its frequency characteristics, which was the case in the Prior Art.

## Claims

1. An electronic integrated circuit comprising a differential amplifier (DIFF) with an associated digital DC offset compensation loop circuit which compensates the offset voltage present at the output (OUTP,OUTPI) of the amplifier **characterized in that** said amplifier has a current feedback differential amplifier construction, in which the emitters of the pair of transistors (Q0, Q1) forming the differential amplifier (DIFF) are connected by a resistor (R4) and the emitter current of said transistors is provided by two current sources (I2, I3), and the digital DC offset voltage compensation loop provides means to modify the value of said current sources (I2, I3).

2. The electronic integrated circuit of claim 1 **characterized in that** said means are a plurality of transistors (M₀ to M_{2N+1}) connected in parallel to two resistors (R2, R3) connected to the emitter of two transistors (Q2, Q3) stimulated by a voltage reference value (VR).

3. A method for amplifying a radio frequency signal using an electronic integrated circuit comprising a differential amplifier (DIFF) with an associated digital DC offset compensation loop circuit which compensates the offset voltage present at the output (OUTP,OUTPI) of the amplifier **characterized in that** the amplification is done by a differential amplifier with current feedback construction, in which the emitters of the pair of transistors (Q0 and Q1) forming the differential amplifier (DIFF) are connected by a resistor (R4) and the emitter current of said transistors is provided by two current sources (I2, I3), and the digital DC offset compensation loop circuit modifies the value of said current sources.

4. The method of claim 3 **characterized in that** to modify the value of the current sources (I2, I3), the digital DC offset voltage compensation activates/deactivates a plurality of transistors (M₀ to M_{2N+1}) connected in parallel to two resistors (R2, R3) connected to the emitter of two transistors (Q2, Q3) stimulated by a voltage reference value (VR).

5. The method of claim 4 **characterized in that** the digital activation/deactivation of said transistors (M₀ to M_{2N+1}) is regulated by a control unit (CU) which iteratively activates/deactivates the corresponding transistors to halve or double the value of the previously used equivalent resistance at the emitter of the two transistors (Q2, Q3) until the DC offset voltage at the output of the differential amplifier reaches zero.
